# EUROPEAN PATENT APPLICATION

(11) **EP 4 661 617 A1**
(43) Date of publication of application: **10.12.2025**
(21) Application number: 25177594.6
(22) Date of filing: 20.05.2025
(51) Int. Cl.: H10D 8/00, H10D 62/10, H10D 64/00

(54) **SEMICONDUCTOR DEVICE**

(30) Priority: 06.06.2024 JP 2024092331
(71) Applicant: Shindengen Electric Manufacturing Co., Ltd., Tokyo 100-0004 (JP)
(72) Inventor: JINGU, Azusa, Saitama, 3518503 (JP); MATSUZAKI, Yoshifumi, Saitama, 3518503 (JP)
(74) Representative: Liesegang, Eva

(57) **Abstract**

information on abstract not available

## Description

### [Technical Field]

The present invention relates to a semiconductor device.

### [Background Art]

Conventionally, there has been known a semiconductor device (conventional semiconductor device) that has an n-type drift layer, and a p-type dopant region that is formed on a surface layer portion of the drift layer, and is in contact with a surface electrode thus constituting a pn diode (for example, see Patent Literature 1).

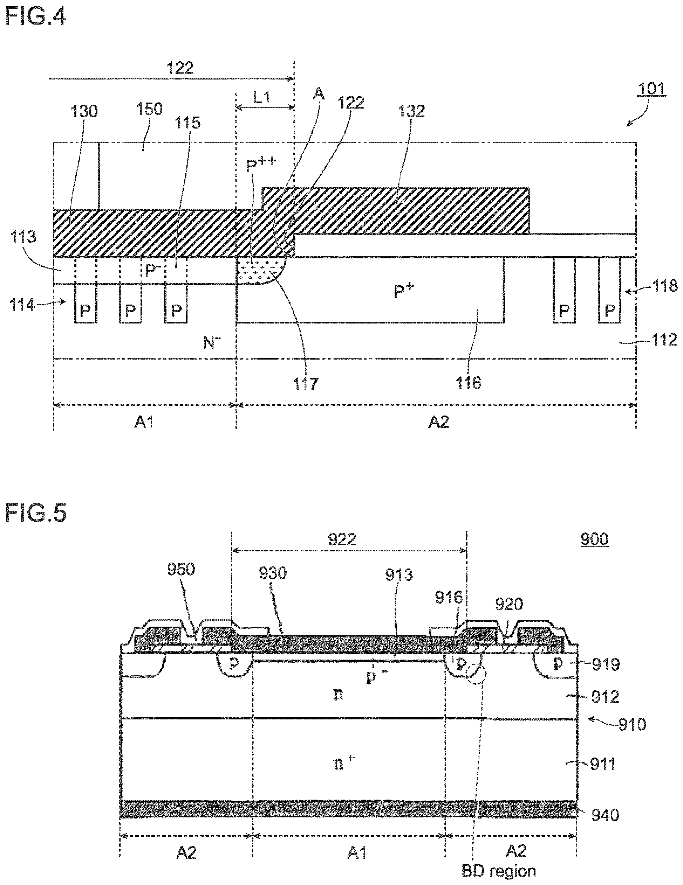

As illustrated in Fig. 5, a conventional semiconductor device 900 includes: a semiconductor base body 910; an insulation layer 920 that is formed on a surface of the semiconductor base body 910, and has an opening 922 through which a surface of the semiconductor base body 910 is exposed; and a surface electrode 930 that is formed in a region that overlaps with the at least opening 922, and is connected with the semiconductor base body 910 at the opening 922.

The semiconductor base body 910 includes: a low resistance semiconductor layer 911 of an n⁺-type; a drift layer 912 of an n-type; a p-type dopant region 913 of a p⁻type formed on a surface layer portion of the drift layer 912; and a p-type peripheral dopant region 916 that is formed on a peripheral edge portion of the p-type dopant region 913 on a surface layer portion of the drift layer 912 and has dopant concentration higher than dopant concentration of p-type dopant region 913.

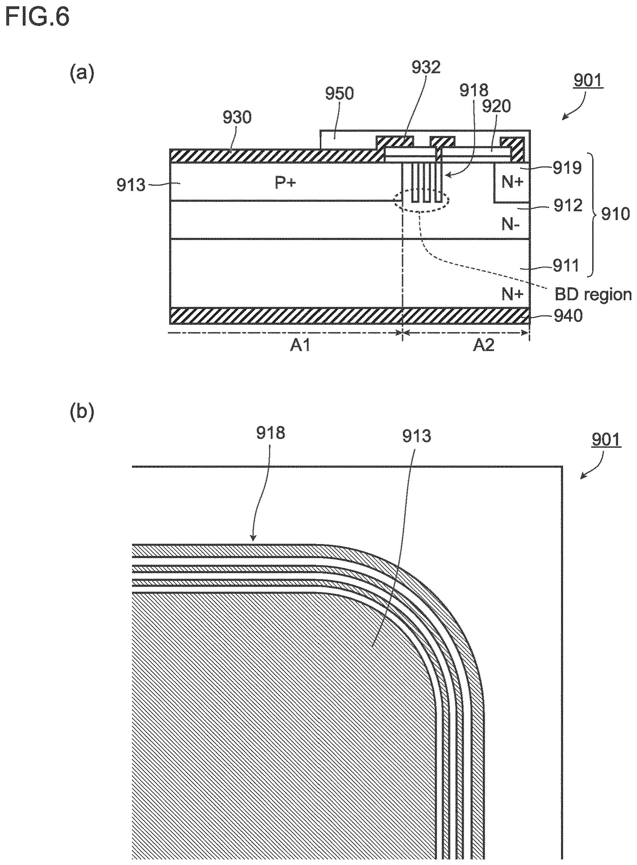

Further, conventionally, there has been also known a semiconductor device 901 where a guard ring 918 is formed in place of the peripheral dopant region 916 (the semiconductor device 901 relating to Background Art, see Fig. 6). A plurality of (three) guard rings 918 are formed outside the p-type dopant region 913 on the surface layer portion of the drift layer 912.

### [Citation List]

### [Patent Literature]

[Patent Literature 1] JP-A-10-335679

### [Summary of Invention]

### [Technical Problem]

However, in the conventional semiconductor device 900 and the semiconductor device 901 relating to the Background Art, when a reverse bias is applied, an electric field is concentrated in an area in the vicinity of a bottom portion of an outermost periphery on the surface layer portion of the drift layer 912, to be more specific, in an area in the vicinity of the bottom portion of the outermost periphery of the peripheral dopant region 916 in the conventional semiconductor device 900 (see a BD region in Fig. 5) and at a bottommost portion of the guard ring 918 in the semiconductor device 901 relating to the Background Art (see the BD region in Fig. 6), and a breakdown occurs in such regions. Accordingly, there exists a drawback that it is difficult to increase a maximum surge reverse power (PRSM) resistance.

In general, to increase a maximum surge reverse power (PRSM) resistance, the structure that is strong against the electric field concentration is formed in such a manner that a peripheral dopant region or a guard ring is formed on an outer peripheral side of the p-type dopant region. However, such a structure has a limit with respect to the PRSM resistance and hence, there has been a demand for a semiconductor device having higher PRSM resistance.

The present invention has been made in view of the above-mentioned circumstances, and it is an object of the present invention to provide a semiconductor device that can increase PRSM resistance.

### [Solution to problem]

A semiconductor device according to the present invention includes: a semiconductor base body; an insulation layer formed on a surface of the semiconductor base body, and having an opening that allows the surface of the semiconductor base body to be exposed; and a surface electrode formed on a region that overlaps with at least the opening, and connected to the semiconductor base body through the opening, wherein the semiconductor base body includes: a drift layer of a first conductive type; a second conductive type dopant region that is formed on a surface layer of the drift layer, and is in contact with the surface electrode; and a plurality of columnar regions of a second conductive type that are arranged in a region where the second conductive type dopant region is formed as viewed in a plan view at a predetermined interval, the columnar regions having dopant concentration higher than dopant concentration of the second conductive type dopant region and deeper than the second conductive type dopant region, and the columnar regions are formed at positions that are vertices of a regular hexagonal shape as viewed in a plan view.

### [Advantageous effects of the present invention]

According to the semiconductor device of the present invention, the semiconductor base body includes: the second conductive dopant type region that is formed on the surface layer portion of the drift layer and is in contact with the surface electrode; and columnar regions that are arranged at predetermined intervals in the region where the second conductive type dopant region is formed as viewed in a plan view, have dopant concentration higher than dopant concentration of the second conductive type dopant region, and are deeper than the second conductive type dopant region. Accordingly, when a reverse bias is applied to the semiconductor device, a place to which an electric field is applied can be expanded from an area in the vicinity of a bottom portion of an outermost periphery in the surface layer portion of the drift layer to the entire region where the second conductive type dopant region is formed (cell region). That is, it is possible to intentionally generate a breakdown in the cell region having a large area before a breakdown occurs in the vicinity of the bottom portion of the outermost periphery of the second conductive type semiconductor region. Accordingly, compared to the conventional semiconductor device and the semiconductor device relating to the Background Art, an area of the region where breakdown occurs is enlarged and hence, a breakdown current easily flows whereby the PRSM resistance can be increased. The semiconductor device has the above-mentioned configuration and hence, the present invention also can acquire advantageous effects such as the reduction of a leak current and the improvement of a recovery characteristic.

Further, according to the semiconductor device of the present invention, as viewed from the predetermined columnar regions, the columnar regions disposed adjacently to each other are formed at positions that form vertices of a regular hexagonal shape as viewed in a plan view. Accordingly, the place to which an electric field is applied is uniformly expanded over the entire region where the second conductive type dopant region is formed (cell region). As a result, a reverse directional current uniformly flows to the entire region where the second conductive type dopant region is formed (cell region) and hence, the PRSM resistance can be further increased.

### [Brief Description of Drawings]

Fig. 1 is a view illustrating a semiconductor device 100 according to an embodiment 1. Fig. 1(a) is an enlarged cross-sectional view of an essential part of the semiconductor device 100, Fig. 1(b) is an enlarged plan view of the essential part illustrating a surface layer portion of a semiconductor base body 110, and Fig. 1(c) is an enlarged plan view of an essential part illustrating the arrangement configuration of columnar regions 114. In Fig. 1(b), the illustration of a channel stop region 119 is omitted.
Fig. 2 is a graph illustrating the probability distribution of PRSM resistance of "prior art structure" and "present invention structure".
Fig. 3 is a view illustrating an electric field distribution when a reverse bias is applied to the semiconductor device 100 according to the embodiment 1.
Fig. 4 is a cross-sectional view illustrating a semiconductor device 101 according to an embodiment 2.
Fig. 5 is a cross-sectional view illustrating a conventional semiconductor device 900. Symbol 919 indicates a channel stop region, symbol 940 indicates a back surface electrode, and symbol 950 indicates a surface protective film.
Fig. 6 is a view illustrating a semiconductor device 901 according to the Background Art. Fig. 6(a) is an enlarged cross-sectional view of an essential part of the semiconductor device 901, Fig. 6(b) is a view illustrating a surface layer portion of the semiconductor base body 910, and symbol 932 indicates a field plate electrode.

### [Description of Embodiments]

Hereinafter, a semiconductor device according to the present invention is described based on embodiments illustrated in the drawings. The embodiments described hereinafter are not intended to limit the present invention called for in claims. Further, it is not always the case that various constitutional elements described in the embodiments and all combinations of these constitutional elements are indispensable as solutions to solve the problems of the present invention.

### [Embodiment 1]

### 1. Configuration of semiconductor device 100 according to embodiment

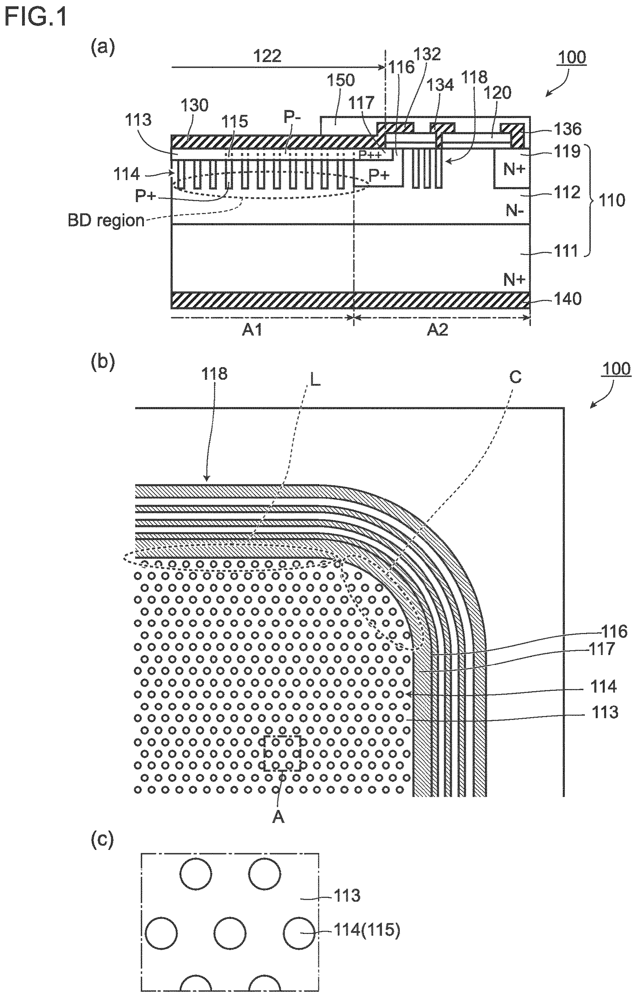

As illustrated in Fig. 1, the semiconductor device 100 according to the embodiment 1 is a diode that includes: a semiconductor base body 110; an insulation layer 120 that is formed on a surface of the semiconductor base body 110, and has an opening 122 through which the surface of the semiconductor base body is exposed; a surface electrode 130 that is formed in a region that overlaps with at least the opening 122, and is connected with the semiconductor base body 110 at the opening 122; a second surface electrode 134 that is disposed at a position spaced apart from the surface electrode 130 on the insulation layer 120, and is electrically connected with a guard ring 118 described later via the opening formed in the insulation layer 120; an equipotential ring electrode 136 (EQR electrode) formed in the vicinity of an outermost periphery of the surface of the semiconductor base body 110; a back surface electrode 140 that is formed on a back surface side of the semiconductor base body 110, and a protective insulation film 150 that has an opening in a center portion thereof.

Although not illustrated in the drawing, the semiconductor device 100 according to the embodiment 1 has an approximately rectangular shape as viewed in a plan view. An element forming region A1 is formed on a center portion of the semiconductor device 100, and an outer peripheral region A2 is formed on an outer peripheral side of the semiconductor device 100 such that the outer peripheral region A2 surrounds the entire circumference of the element forming region A1. In the embodiment 1, a region that is on a more inner peripheral side than an inner peripheral end of a peripheral dopant region 116 described later is set as the element forming region A1, and a region that is more outer peripheral side than the inner peripheral end of the peripheral dopant region 116 is set as the outer peripheral region A2.

The opening 122 of the insulation layer 120 is formed such that the entire region of the element forming region A1 and a portion of the outer peripheral region A2 are exposed through the opening 122. As a material for forming the insulation layer 120, a suitable material can be used.

The surface electrode 130 is formed in a creeping-up state such that the surface electrode 130 covers an inner peripheral end portion of the insulation layer 120, and the surface electrode on the insulation layer 120 constitutes a field plate electrode 132. The surface electrode 130 extends to an area outside the peripheral dopant region 116 as viewed in a plan view.

As illustrated in Fig. 1(a), the semiconductor base body 110 includes a low resistance semiconductor layer 111, a drift layer 112, a p-type dopant region 113 (secondconductive-type dopant region), a columnar region 114, a first high concentration region 115, a peripheral dopant region 116, a second high concentration region 117, the guard ring 118 and a channel stop region 119.

The low resistance semiconductor layer 111 of an n⁺-type is formed on a back surface side of the semiconductor base body 110.

The drift layer 112 is a semiconductor layer of an n⁻-type (first conductive type) that is formed on a surface side of the low resistance semiconductor layer 111 and has concentration lower than the concentration of the low resistance semiconductor layer 111. The low resistance semiconductor layer 111 and the drift layer 112 are formed on the entire surface of the element forming region A1 and the outer peripheral region A2. The dopant concentration of the drift layer 112 falls within a range of 1.0 × 10¹³ cm⁻³ to 1.0 × 10¹⁵ cm⁻³, for example.

The p-type dopant region 113 is a semiconductor region of a p⁻type that is formed on a surface layer portion of the drift layer 112. The p-type dopant region 113 is formed within the element forming region A1 and a predetermined region of the outer peripheral region A2. To be more specific, the p-type dopant region 113 is formed to a region outside an inner peripheral end of the insulation layer 120, and is brought into contact with the surface electrode 130. An outer peripheral end of the p-type dopant region 113 is disposed on an inner peripheral side than an outer peripheral end of the peripheral dopant region 116. The p-type dopant region 113 is formed in an approximately rectangular shape having an arcuate corner as viewed in a plan view, and has a plurality of corner portion C and a plurality of side portions L. The dopant concentration of the p-type dopant region 113 falls within a range of 5.0 × 10¹⁵ cm⁻³ to 4.4 × 10¹⁶ cm⁻³.

The columnar region 114 is formed of a plurality of columnar regions arranged at a predetermined interval in a region where the p-type dopant region 113 is formed. The dopant concentration in the columnar region 114 is higher than the dopant concentration in the p-type dopant region 113, and a depth of the columnar region 114 is greater than a depth of the p-type dopant region 113.

With respect to the columnar regions 114, as viewed from the predetermined columnar region 114, the columnar region 114 disposed adjacently to the predetermined columnar region 114 is formed at a position that forms a vertex of a regular hexagonal shape as viewed in a plan view. That is, as illustrated in Fig. 1(b) and Fig. 1(c), the columnar regions 114 are arranged in a staggard shape where vertexes of the respective triangular shapes are arranged in a region where the p-type dopant region 113 is formed. All intervals between the columnar regions 114 disposed adjacently to each other are set equal.

In the columnar region 114, in the corner portion C, an area of regions where the columnar regions 114 are formed per unit area is set smaller than an area of regions where the columnar regions 114 are not formed (the region of the p-type dopant region 113) per unit area. To be more specific, in the corner portion C, the columnar regions 114 are not formed at positions that are in contact with the second high concentration region 117 so that the columnar regions 114 are in a so-called thin-out state. Accordingly, in the corner portion C, an area of the region of the p-type dopant region 113 is larger than an area of the region of the columnar region 114.

Further, in a region of the p-type dopant region 113 other than the corner portion C (a region on a peripheral portion and a region on an inner side), an area of a region where the columnar regions 114 are formed per unit area is equal to an area of a region where the columnar regions 114 are not formed (the region of the p-type dopant region 113) per unit area.

The first high concentration region 115 is a region where the p-type dopant region 113 and the columnar region 114 overlap with each other. The first high concentration region 115 has the higher dopant concentration than other regions of the p-type dopant region 113 (regions other than the first high concentration region 115 in the p-type dopant region 113). Accordingly, the dopant concentration is increased in the ascending order of the p-type dopant region 113, the columnar region 114 and the first high concentration region 115.

The peripheral dopant region 116 has a portion that is formed on a peripheral edge of the p-type dopant region 113 on a surface layer portion of the drift layer 112 and overlaps with the p-type dopant region 113. Dopant concentration of the peripheral dopant region 116 is higher than dopant concentration of the p-type dopant region 113. The peripheral dopant region 116 has the same depth as the depth of the columnar regions 114, and has the depth greater than the depth of the p-type dopant region 113. An outermost periphery of the peripheral dopant region 116 is disposed outside an outermost periphery of the p-type dopant region 113, and is disposed inside an outermost periphery of the surface electrode 130 (field plate electrode 132). The peripheral dopant region 116 is connected to the surface electrode 130 via the second high concentration region 117 described later.

The second high concentration region 117 is formed on a portion where the p-type dopant region 113 and the peripheral dopant region 116 overlap with each other, and has a higher dopant region in other regions of the p-type dopant region 113 (the regions of the p-type dopant region 113 other than the second high concentration region 117), other regions of the peripheral dopant region 116 (regions of the peripheral dopant regions 116 other than the second high concentration region 117). The dopant concentration of the second high concentration region 117 is within a range of 1.0 × 10¹⁶cm⁻³ to 1.0 × 10²⁰cm⁻³, and more preferably within a range of 2.0 × 10¹⁷cm⁻³ to 1.0 × 10²⁰cm⁻³.

In the embodiment 1, the second high concentration region 117 is formed only in the region where the p-type dopant region 113 and the peripheral dopant region 116 overlap with each other. However, besides the overlapping region, the second high concentration region 117 may be also formed on an inner peripheral side of the overlapping region.

The guard ring 118 is a p-type region that is formed outside the peripheral dopant region 116 on a surface layer portion of the drift layer 112. Dopant concentration of the guard ring 118 is higher than dopant concentration of the p-type dopant region 113. A depth of the columnar region 114 is as same as a depth of the guard ring 118. Further, a width of the guard ring 118 is as same as a diameter of the columnar region 114.

The channel stop region 119 is connected to an EQR electrode 136 that is positioned on an outermost periphery of the semiconductor base body 110. The dopant concentration of the channel stop region 119 is higher than the dopant concentration of the drift layer 112.

In the embodiment 1, the recoupling center is not formed in the semiconductor base body 110. However, the recoupling center may be formed in the semiconductor base body 110. The recoupling center may be formed by irradiating electron beams to the semiconductor base body 110 (and, thereafter, by annealing the semiconductor base body 110) the recoupling center to the semiconductor base body 110, or may be formed by applying heavy metal (for example, platinum or gold) to the semiconductor base body by coating and by diffusing heavy metal by heating.

### 2. PRSM resistance and potential distribution in semiconductor device 100 according to embodiment 1

Next, it is described that PRSM resistance of the semiconductor device 100 according to the embodiment 1 is more favorable than PRSM resistance of the semiconductor device 900 of the prior art. In this embodiment, "present invention structure" having substantially the same configuration as the semiconductor device according to the embodiment 1 and a semiconductor device of "prior art structure" are actually prepared, and the evaluation of PRST resistance is performed.

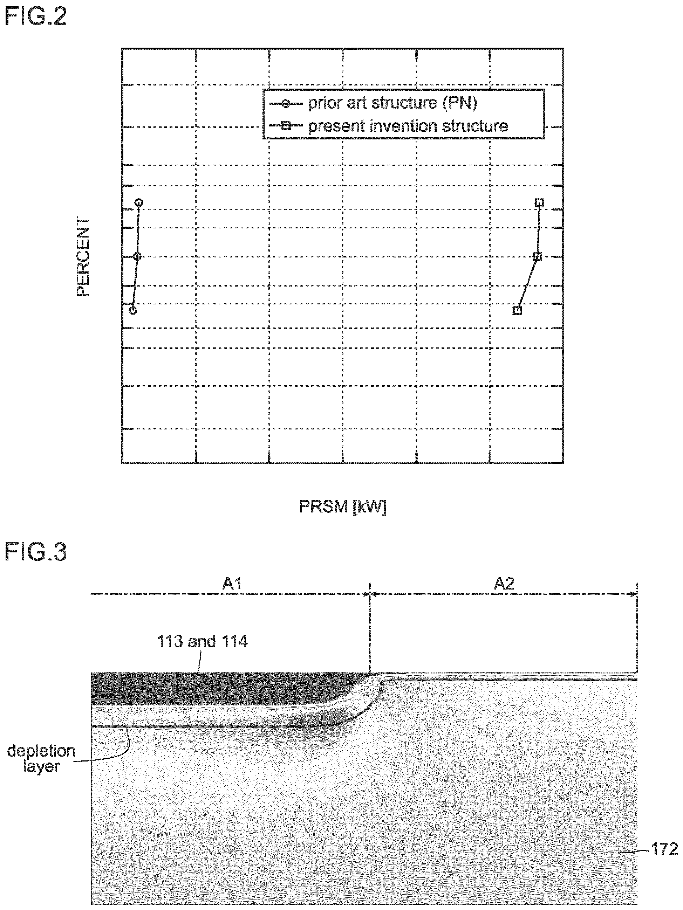

Fi. 2 is a graph illustrating the probability distribution of the PRSM resistance relating to "present invention structure" and "prior art structure". In Fig. 2, PRSM resistance is taken on an axis of abscissas. In Fig. 2, "percent" that is taken on an axis of ordinates in Fig. 2 indicates a cumulative probability of PRSM resistance of "prior art structure" and "present invention structure".

First, the semiconductor device having "present invention structure" and the semiconductor device having the "prior art structure" are prepared. The semiconductor device having "present invention structure" is a semiconductor device that has substantially the same structure as the semiconductor device 100 according to the embodiment 1 except for a point that an area ratio between the p-type dopant region 113 and the columnar regions 114 in the corner portion C of the p-type dopant region 113 is 1:1. Although not illustrate in the drawing, the semiconductor device according to "prior art structure" is a semiconductor device that has substantially the same structure as the semiconductor device 100 according to the embodiment 1 except for a point that the semiconductor device does not have the columnar region 114.

PRSM resistances of the semiconductor device according to "present invention structure" and the semiconductor device according to "prior art structure" prepared in this manner were measured, and cumulative probabilities of the measured PRSM resistances were plotted.

As illustrated in Fig. 2, in "the present invention structure", cumulative probability is plotted with a maximum surge reverse power resistance (PRSM resistance) of a high value. On the other hand, in the "conventional structure", cumulative probability is plotted with a maximum surge reverse power resistance (also referred to as "peak surge reverse power resistance") (PRSM resistance) of a low value. Accordingly, it was confirmed that the PRSM resistance of the semiconductor device 100 according to the embodiment 1 is more favorable than the PRSM resistance of the semiconductor device according to the conventional structure.

Next, the potential distribution of the semiconductor device 100 according to the embodiment 1 is described. Fig. 3 is a view illustrating an electric field distribution when a reverse bias is applied to the semiconductor device 100 according to the embodiment. A solid line in Fig. 3 indicates a depletion layer.

As illustrated in Fig. 3, in the semiconductor device 100 according to the embodiment 1, when a reverse bias is applied, a region where a potential is high is not the outer peripheral region A2, and a potential becomes high in a relatively large region of the element forming region A1. Accordingly, it was confirmed that an electric field is dispersed in the element forming region A1, and breakdown occurs in the element forming region A1. From the above, it was confirmed that an area of the region where breakdown occurs becomes wide and hence, a breakdown current easily flows and hence, PRSM resistance can be increased.

In the conventional semiconductor device, it is considered that, when a reverse bias is applied, an electric field is concentrated on an area in the vicinity of the bottom portion of the outermost periphery on the surface layer portion of the drift layer 912, more specifically, in the vicinity of the bottom portion of the outermost periphery of the peripheral region in the conventional semiconductor device 900 (see a BD region in Fig. 5) and hence, breakdown occurs in such a region. A breakdown current hardly flows and hence, it is considered difficult to increase a PRSM resistance to a predetermined value or more.

### 3. Advantageous effects of semiconductor device 100 according to embodiment 1

According to the semiconductor device 100 of the embodiment 1, the semiconductor base body 110 includes: the p-type dopant region 113 that is formed on the surface layer portion of the drift layer 112, and is in contact with the surface electrode 130; and columnar regions 114 that are arranged at predetermined intervals in the region where the p-type dopant region 113 is formed as viewed in a plan view, has dopant concentration higher than dopant concentration of the p-type dopant region 113, and is deeper than the p-type dopant region. Accordingly, when a reverse bias is applied to the semiconductor device 100, a region to which an electric field is applied can be expanded from the area in the vicinity of the bottom portion of the outermost periphery in the surface layer portion of the drift layer 112 to the entire region where the p-type dopant region 113 is formed (element forming region A1). That is, it is possible to intentionally generate a breakdown in the element forming region A1 having a large area before a breakdown occurs in an area in the vicinity of the bottom portion of the outermost periphery of the p-type dopant region 113. Accordingly, compared to the conventional semiconductor device and the semiconductor device relating to the Background Art, an area of the region where breakdown occurs is enlarged and hence, a breakdown current easily flows whereby the PRSM resistance can be increased.

Further, according to the semiconductor device 100 of the embodiment 1, as viewed from the predetermined columnar regions 114, the columnar regions 114 disposed adjacently to each other are formed at positions that form vertices of a regular hexagonal shape as viewed in a plan view. Accordingly, the places to which an electric field is applied can be uniformly expanded over the entire region where the p-type dopant region 113 is formed (element forming region A1). As a result, a reverse directional current uniformly flows to the entire region where the p-type dopant region 113 is formed (element forming region A1) and hence, the PRSM resistance can be further increased.

Further, according to the semiconductor device 100 of the embodiment 1, the surface electrode 130 expands to an outside of the p-type dopant region 113 as viewed in a plan view, and at the corner portion C, an area of the region where the columnar regions 114 per unit area are formed is smaller than an area of a region where the columnar regions 114 per unit area are not formed and hence, the concentration of an electric field can be easily induced to the element forming region A1 than the outer peripheral region A2. As a result, breakdown can be easily generated in the element forming region A1.

Further, according to the semiconductor device 100 of the embodiment 1, in regions of the p-type dopant region 113 other than the corner portion C, an area of the region where the columnar regions 114 per unit area are formed is equal to an area of the region where the columnar regions 114 per unit area are not formed (the region of the p-type dopant region 113) and hence, in the element forming region A1, the places where an electric field is applied can be uniformly expanded on the entire region of the element forming region where the p-type dopant region 113 is formed (element forming region A1). Accordingly, it is possible to prevent an electric field from being locally concentrated at a specific portion of the element forming region A1 and hence, it is possible to prevent breakdown from being generated at the specific place.

In a case where the plurality of columnar region 114 are arranged at a predetermined intervals in the region where the p-type dopant region 113 is formed, when holes that are recovered via the columnar regions 114 and move to the surface electrode 130 at the time of a reverse recovery pass a region where the p-type dopant region 113 and the columnar regions 114 overlap with each other. Accordingly, there is a concern that the current density of the region is increased. However, according to the semiconductor device 100 of the embodiment 1, the first high concentration region 115 having higher dopant concentration than other regions of the p-type dopant region 113 is formed in the region where the p-type dopant region 113 and the columnar region 114 overlap with each other and hence, the holes easily flow whereby the current density in the region can be reduced. As a result, a sharp increase of a recovery current in the region can be prevented and hence, a recovery characteristic can be improved. Further, the current density in the region can be reduced and hence, the elevation of a temperature of the semiconductor device 100 can be also suppressed.

Further, the semiconductor device 100 according to the embodiment 1 includes the p-type peripheral dopant region 116 that is formed on a peripheral edge portion of the p-type dopant region 113 on the surface layer portion of the drift layer 112, has a portion that overlaps with the p-type dopant region 113, and has dopant concentration higher than dopant concentration of the p-type dopant region. Accordingly, by reducing a gradient of the dopant concentration of the outer peripheral end portion of the p-type dopant region 113, breakdown in the outer peripheral end portion of the p-type dopant region 113 can be suppressed. As a result, the PRSM resistance in the outer peripheral region A2 can be improved.

Further, according to the semiconductor device 100 of the embodiment 1, a depth of the columnar regions 114 is equal to a depth of the peripheral dopant region 116 and hence, when a reverse bias is applied, it is possible to prevent an electric field from being concentrated on an area in the vicinity of the bottom portion of the outermost periphery of the peripheral dopant region 116. Accordingly, the portion on which an electric field is concentrated can be expanded from an area in the vicinity of the bottom portion of the outermost periphery on the surface layer portion of the drift layer 112 to the entire region where the p-type dopant region 113 is formed (element forming region A1). As a result, while improving the PRSM resistance in the outer peripheral region A2, the PRSM resistance can be enhanced also from a viewpoint of the entire semiconductor device.

The semiconductor device 100 according to the embodiment 1 includes the p-type guard ring 118 having dopant concentration higher than dopant concentration of the p-type dopant region 113 outside the peripheral dopant region 116 on the surface layer portion of the drift layer 112. Accordingly, it is possible to extend a depletion layer to the outer peripheral region A2 before an electric field of the outermost region in the element forming region A1 that is liable to cause the electric field concentration exceed a critical electric field. Accordingly, a withstand voltage of the outer peripheral region A2 can be increased.

According to the semiconductor device 100 of the embodiment 1, the depth of the columnar regions 114 is equal to the depth of the guard ring 118 and hence, when a reverse bias is applied, it is possible to prevent an electric field from concentrating in an area in the vicinity of the bottom portion of the outermost periphery of the guard ring 118. Accordingly, it is possible to expand the place on which an electric field is concentrated can be expanded from an area in the vicinity of the bottom portion of the outermost periphery on the surface layer portion of the drift layer 112 to the entire region where the p-type dopant region 113 is formed (element forming region A1). As a result, while improving the PRSM resistance in the outer peripheral region A2, it is possible to provide the semiconductor device having further higher PRSM resistance over the entire semiconductor device.

The columnar regions 114, the peripheral dopant region 116 and the guard ring 118 have the same depth and hence, it is possible to extend a depletion layer to the outer peripheral region A2 before an electric field in the outermost region of the element forming region A1 where the electric field concentration is liable to be generated exceeds a critical electric field and hence, the local concentration of an electric field can be prevented.

According to the semiconductor device 100 of the embodiment 1, a diameter of the columnar region 114 is equal to a width of the guard ring 118 and hence, the columnar region 114 and the guard ring 118 can be formed collectively.

The semiconductor device 100 of the embodiment 1 includes the second high concentration region 117 having the higher dopant concentration than other portions of the p-type dopant region 113 in the portion where the p-type dopant region 113 and the peripheral dopant region 116 overlap with each other. With such a configuration, it is possible to prevent holes in the outer peripheral region A2 from flowing onto a surface of the element forming region A1 attributed to the difference in dopant concentration between the p-type dopant region 113 and the peripheral dopant region 116. Accordingly, it is possible to prevent the increase of the current density on the surface of the element forming region A1 and hence, it is possible to provide a semiconductor device that further enhances the breakdown resistance.

According to the semiconductor device 100 of the embodiment 1, the surface electrode 130 (field plate electrode 132) expands to an area outside the p-type peripheral dopant region 116 as viewed in a plan view. Accordingly, it is possible to prevent an electric field from being concentrated on a pn junction (particularly, an area in the vicinity of the surface of the semiconductor base body 110) between the p-type peripheral dopant region 116 of the semiconductor base body surface layer portion and the drift layer 112 and hence, a breakdown resistance can be increased.

In the embodiment 1, the guard ring 118 on an outermost periphery is also connected to the second surface electrode 134, and the second surface electrode 134 also extends toward an outer peripheral side, and such structure can also acquire substantially the same advantageous effects as the above-mentioned field plate electrode 132.

### [Embodiment 2]

A semiconductor device 101 according to an embodiment 2 has basically substantially the same configuration as the semiconductor device 100 according to the embodiment 1. However, the semiconductor device 101 according to the embodiment 2 differs from the semiconductor device 100 according to the embodiment 1 with respect to the position of the inner peripheral end of the peripheral dopant region on the surface of the semiconductor base body. That is, in the semiconductor device 101 of the embodiment 2, an inner peripheral end of the p-type peripheral dopant region 116 on the surface of a semiconductor base body 110 is, as illustrated in Fig. 4, positioned on an inner peripheral side of an end portion of an opening 122. Accordingly, the p-type peripheral dopant region 116 is in contact with a surface electrode 130.

An inner peripheral end of the p-type peripheral dopant region 116 on the surface of the semiconductor base body 110 is positioned on an inner peripheral side of an end portion A of the opening 122, and a length L1 from the inner peripheral end of the p-type peripheral dopant region 116 to the end portion A of the opening 122 is not less than 0.01µm and less than 30µm.

In this manner, the semiconductor device 101 according to the embodiment 2 differs from the semiconductor device 100 according to the embodiment 1 with respect to the position of the inner peripheral end of the peripheral dopant region on the surface of the semiconductor body. However, in the same manner as the case of the semiconductor device 100 according to the embodiment 1, the semiconductor base body 110 includes: a p-type dopant region 113 that is formed on a surface layer portion of a drift layer 112 and is in contact with the surface electrode 130; and a plurality of columnar regions 114 that are arranged at a predetermined interval in a region where the p-type dopant region 113 is formed, have a dopant concentration higher than a dopant concentration of the p-type dopant region 113, and are deeper than the p-type dopant region. Accordingly, when a reverse bias is applied, a portion to which an electric field is applied can be expanded from an area in the vicinity of a bottom portion of an outermost periphery on a surface layer portion of the drift layer 112 to an entire region where the p-type dopant region 113 is formed (element forming region A1). That is, it is possible to intentionally cause breakdown in an element forming region A1 having a large area before a breakdown occurs in the vicinity of the bottom portion of the outermost periphery of the p-type dopant region 113. Accordingly, compared to the conventional semiconductor device and the semiconductor device described in the Background Art, an area in which breakdown occurs can be enlarged and hence, a breakdown current easily flows whereby a PRSM resistance cab be increased.

Further, according to the semiconductor device 101 of the embodiment 2, the inner peripheral end of the peripheral dopant region 116 on the surface of the semiconductor base body 110 is positioned on an inner peripheral side of the end portion A of the opening 122, the length L1 from the inner peripheral end of the peripheral dopant region 116 to the end portion A of the opening 122 is not less than 0.01µm and less than 30µm. Accordingly, at the time of turning on or off the switching, holes and the like that are generated in the semiconductor base body 110 including the outer peripheral region A2 can be recovered by the recoupling center and hence, a current quantity itself that reaches the surface electrode 130 can be reduced (the number of holes that reach the surface electrode 130 can be reduced). Accordingly, both a current that flows into the surface electrode 130 via the p-type dopant region 113 and a current that flows into the surface electrode 130 via the peripheral dopant region 116 can be reduced and hence, current density in the vicinity of a merged point can be reduced whereby a temperature rise can be suppressed. As a result, a breakdown resistance can be increased. Further, current density of the element forming region A1 can be reduced and hence, the length L1 from the inner peripheral end of the peripheral dopant region 116 to the end portion of the opening 122 can be reduced. Accordingly, a sharp increase of a recovery current can be prevented and hence, a recovery characteristic can be improved whereby an increase of a recovery loss can be suppressed.

The semiconductor device 101 according to the embodiment 2 has substantially the same configuration as the semiconductor device 100 according to the embodiment 1 except for the position of the inner peripheral end of the peripheral dopant region on the surface of the semiconductor base body. Accordingly, the semiconductor device 101 according to the embodiment 2 acquires the same advantageous effects with respect to the corresponding components in the semiconductor device 100 according to the embodiment 1 amongst all advantageous effects of the semiconductor device 100 according to the embodiment 1.

Although the present invention has been described based on the above-mentioned embodiments, the present invention is not limited to the above-mentioned embodiments. The present invention can be carried out in various modes without departing from the gist of the present invention and, for example, the following modifications are also conceivable.

(1) The positions, connections, the number of components and the like described in the above-mentioned respective embodiments (including the respective modifications, the same definition adopted hereinafter) are provided for an exemplifying purpose, and can be changed within a range that the advantageous effects of the present invention are not impaired.
(2) In the above-mentioned respective embodiments, the diode is used as the semiconductor device. However, the present invention is not limited to such a case. As the semiconductor device, a MOSFET or an IGBT may be used, or other suitable semiconductor devices may be used.
(3) In the above-mentioned respective embodiments, the first high concentration region 115 is formed in the region where the p-type dopant region 113 and the peripheral dopant region 116 overlap with each other. However, the present invention is not limited to such a case. The high concentration region may be also formed in a region other than the above-mentioned overlapping region in the second conductive type dopant region. However, from an aspect of the recovery characteristic, it is not preferred that the entire second conductive dopant region is formed of the high concentration region, and it is preferred that the region other than the high concentration region is included.
(4) In the above-mentioned respective embodiments, the peripheral dopant region 116, the second high concentration region 117, and the guard ring 118 are formed in the outer peripheral region A2. However, the present invention is not limited to such a case. The present invention is established even when any one or none of these constitutional elements are not included.

### [Reference Signs List]

100, 101: semiconductor device
110: semiconductor base body
112: drift layer
113: p-type dopant region (second conductive type dopant region)
114: columnar region
115: first high concentration region
116: peripheral dopant region
117: second high concentration region
18: guard ring
120: insulation layer
122: opening
130: surface electrode

## Claims

1. A semiconductor device comprising:
a semiconductor base body;
an insulation layer formed on a surface of the semiconductor base body, and having an opening that allows the surface of the semiconductor base body to be exposed; and
a surface electrode formed on a region that overlaps with at least the opening, and connected to the semiconductor base body through the opening, wherein
the semiconductor base body includes:
a drift layer of a first conductive type;
a second conductive type dopant region that is formed on a surface layer portion of the drift layer and is in contact with the surface electrode; and
a plurality of columnar regions of a second conductive type that are formed in a region where the dopant region of a second conductive type is formed as viewed in a plan view at a predetermined interval, the columnar regions having dopant concentration higher than dopant concentration of the dopant region of the second conductive type region and deeper than the second conductive type dopant region, and
the columnar regions that are disposed adjacently to each other are formed at positions that are vertices of a regular hexagonal shape as viewed in a plan view.

2. The semiconductor device according to claim 1, wherein the surface electrode expands to an outside of the second conductive type dopant region as viewed in a plan view,
the second conductive type dopant region includes a plurality of corner portions and a plurality of side portions as viewed in a plan view, and
at the corner portion, an area of regions where the columnar regions are formed is smaller than an area of a region where the columnar regions are not formed.

3. The semiconductor device according to claim 2 wherein in a region other than a corner portion of the second conductive type dopant region, an area of the region where the columnar regions are formed is equal to an area of a region where the columnar regions are not formed.

4. The semiconductor device according to any one of claims 1 to 3, wherein a first high concentration region having higher dopant concentration than other regions of the second conductive type dopant region is formed in a region where the second conductive type dopant region and the columnar regions overlap with each other.

5. The semiconductor device according to any one of claims 1 to 4, wherein the semiconductor base body further includes a peripheral dopant region of a second conductive type that has a portion that is formed on a peripheral edge portion of the second conductive type dopant region on a surface layer portion of the drift layer and overlaps with the second conductive type dopant region, and has dopant concentration that is higher than dopant concentration of the second conductive type dopant region, and
a depth of the peripheral dopant region is equal to a depth of the columnar regions.

6. The semiconductor device according to claim 5, wherein the semiconductor base body further includes a guard ring of a second conductive type that is disposed outside the peripheral dopant region on a surface layer portion of the drift layer, and has dopant concentration higher than dopant concentration of the second conductive type dopant region, and
a depth of the columnar region is equal to a depth of the guard ring.

7. The semiconductor device according to claim 6, wherein a width of the guard ring is equal to a diameter of the columnar region.

8. The semiconductor device according to any one of claims 5 to 7, wherein the semiconductor base body has a second high concentration region having dopant concentration higher than dopant concentration in other regions of the second conductive type dopant region at a portion where the second conductive type dopant region and the peripheral dopant region overlap with each other.

9. The semiconductor device according to any one of claims 5 to 8, wherein the surface electrode expands outside the peripheral dopant region as viewed in a plan view.
